(19) Europäisches Patentamt
European Patent Office
Office européen des brevets

(11) **EP 2 597 536 A1**

(12) # DEMANDE DE BREVET EUROPEEN

(43) Date de publication:
**29.05.2013 Bulletin 2013/22**

(21) Numéro de dépôt: **11190694.7**

(22) Date de dépôt: **25.11.2011**

(51) Int Cl.:
**G04B 17/06** (2006.01) **G04B 17/22** (2006.01)
**F16F 1/10** (2006.01) **H03H 9/02** (2006.01)
**B23K 26/06** (2006.01)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(71) Demandeur: **CSEM Centre Suisse d'Electronique et de Microtechnique SA - Recherche et Développement**
**2002 Neuchâtel (CH)**

(72) Inventeurs:
• **Niedermann, Philippe**
**2034 Peseux (CH)**
• **Baborowski, Jacek**
**2012 Auvernier (CH)**

(74) Mandataire: **GLN SA**
**Avenue Edouard-Dubois 20**
**2000 Neuchâtel (CH)**

(54) **Ressort spiral amélioré et procédé de fabrication dudit ressort spiral**

(57) La présente invention concerne un ressort spiral (2) destiné à équiper un balancier (3) d'une pièce d'horlogerie mécanique, formé d'un barreau (1) en spirale issu d'un usinage d'une plaque de verre de quartz, lequel présente un coefficient thermique de rigidité positif, caractérisé en ce que le barreau (1) constitue une âme (4) recouverte au moins localement d'au moins une couche externe (5) de structure différente pour modifier le coefficient thermique de rigidité.

Fig. 4

EP 2 597 536 A1

**Description**

Domaine technique

La présente invention se rapporte au domaine technique général de l'organe régulateur des pièces d'horlogerie, appelé balancier-spiral. Elle concerne, plus particulièrement, d'une part, un ressort spiral destiné à équiper le balancier d'une pièce d'horlogerie mécanique et, d'autre part, un procédé de fabrication d'un tel spiral.

L'organe régulateur des montres mécaniques est composé d'un volant d'inertie, appelé balancier et d'un ressort en spirale, appelé spiral ou ressort spiral, lequel est fixé par une extrémité sur l'axe du balancier et par l'autre extrémité sur un pont, appelé coq, dans lequel pivote l'axe du balancier.

Le balancier-spiral oscille autour de sa position d'équilibre (ou point mort). Lorsque le balancier quitte cette position, il arme le spiral. Cela crée un couple de rappel qui, lorsque le balancier est libéré, le fait revenir à sa position d'équilibre. Comme il a acquis une certaine vitesse, donc une énergie cinétique, il dépasse son point mort jusqu'à ce que le couple contraire du spiral l'arrête et l'oblige à tourner dans l'autre sens. Ainsi, le spiral régule la période d'oscillation du balancier.

Le ressort spiral équipant les mouvements de montres mécaniques est par exemple une lame métallique élastique de section rectangulaire enroulée sur elle-même en spirale d'Archimède et comportant de 12 à 15 tours. On rappellera que le spiral est principalement caractérisé par son couple de rappel M, exprimé en première approximation par la formule:

$$M = E/L \; (w^3 \cdot t/12 \cdot \varphi)$$

avec :

- E : module d'Young de la lame [N/m2],
- t : épaisseur du spiral,
- w : largeur du spiral,
- L : longueur du spiral,
- $\varphi$ : angle de torsion (rotation du pivot)

On comprendra aisément que la constante de rappel ou rigidité d'un spiral

$$C = M/\varphi,$$

qui caractérise le couple de rappel par unité d'angle de torsion, doit être le plus stable possible, quels que soient, notamment, la température et le champ magnétique. La matière utilisée a donc une importance primordiale.

Or, on sait que le module d'Young d'une lame élastique varie avec la température, ce qui influence le comportement du spiral et la régularité de la marche de l'organe régulateur qu'il équipe. Affranchir le fonctionnement de l'organe régulateur de l'influence de la température est un enjeu de longue date pour les horlogers.

Etat de la technique

On a par exemple cherché à produire des spiraux dont le module d'Young dépend aussi faiblement que possible de la température. On connaît ainsi par l'intermédiaire du document CH 307 683, des verres dont la teneur en silice est comprise entre 75% et 85% utilisés pour former un élément élastique pour appareils chronométriques. Ces verres ont la particularité de présenter un coefficient thermo-élastique quasiment nul. Ils sont toutefois difficiles à mettre en forme avec précision et à manipuler.

On connaît également, par l'intermédiaire du document EP 1 791 039, un ressort spiral présentant un coefficient thermique du module d'Young voisin de zéro. Ce document décrit également son procédé de fabrication. Le matériau constitutif du spiral est du verre photostructurable (p.ex.le Foturan). La modification du verre, sur au moins certaines zones des spires, est obtenue par l'intermédiaire d'une irradiation UV pour modifier son coefficient thermique du module d'Young, via une réaction chimique spécifique d'éléments métalliques contenus dans le verre. L'irradiation UV est également utilisée en association avec un traitement thermique à haute température pour éliminer ensuite, grâce à une attaque chimique, les zones de matières localisées entre les spires du ressort spiral. La mise en oeuvre d'un tel procédé de fabrication est longue est complexe. La mise en oeuvre dudit procédé nécessite des moyens techniques de fabrication et de contrôle complexes et coûteux, notamment pour effectuer un traitement localisé à haute température. La sélectivité entre la zone irradié et non irradié est de l'ordre de 10.

Divulgation de l'invention

L'invention vise à remédier aux inconvénients précités en fournissant un ressort spiral dont la fabrication est simple, précise et reproductible.

L'invention a également pour but de fournir un ressort spiral thermo-compensé, pour compenser la dérive thermique de sa fréquence de résonnance (TCF) de manière efficace et durable.

Les buts de l'invention sont atteints à l'aide d'un ressort spiral et de son procédé de fabrication tels que définis dans les revendications.

Dans la présente, le matériau appelé « verre de quartz » est défini de manière large pour désigner un matériau produit à partir de quartz synthétique ou de silice synthétique.

Brève description des dessins

D'autres caractéristiques de la présente invention apparaîtront plus clairement à la lecture de la description qui va suivre, faite en référence au dessin annexé, donné à titre d'exemple non limitatif, dans lequel:

- la figure 1, illustre une section transversale d'un exemple de barreau en spirale formant un ressort spiral conforme à l'invention,
- la figure 2a représente un exemple de réalisation d'un ressort spiral conforme à l'invention,
- la figure 2b représente un exemple de réalisation d'un ensemble ressort spiral-balancier conforme à l'invention,
- les figures 3, 4 et 5, illustrent diverses variantes de réalisation d'une compensation thermomécanique du barreau de la figure 1, et
- la figure 6 illustre une section transversale d'un exemple barreau en spirale obtenu selon l'invention.

Mode(s) de réalisation de l'invention

Les éléments structurellement et fonctionnellement identiques et présents sur plusieurs figures distinctes, sont affectés d'une même référence numérique ou alphanumérique.

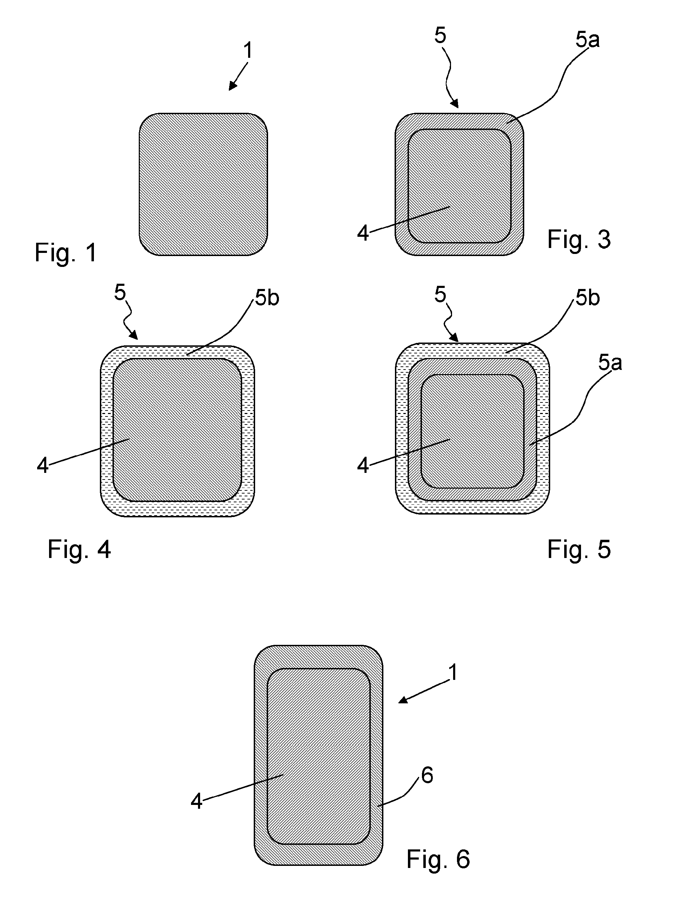

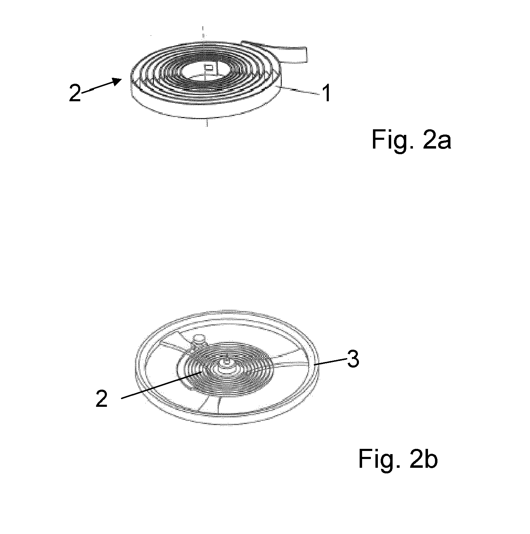

La figure 1 illustre une section transversale d'un exemple de barreau 1 en spirale, destiné à former un ressort spiral 2 conforme à l'invention, illustré par exemple à la figure 2a.

Selon l'invention, le barreau 1 est réalisé à base de verre de quartz. Le verre de quartz est un matériau amorphe et isotrope présentant un coefficient thermique de rigidité TCE positif d'environ 200 ppm/°K et un coefficient de dilatation thermique d'environ 0,38 ppm/°K. Il est constitué de manière exclusive, impuretés mises à part, de $SiO_2$, sans addition de fondant.

Le barreau 1 est avantageusement issu d'un usinage d'un substrat en verre de quartz, prenant la forme d'une feuille (ou wafer) de verre de quartz. Le procédé consiste à utiliser un laser femtoseconde pour balayer son point focal variable sur le substrat et pour exposer le substrat au rayonnement dudit laser, au moins le long d'une zone de séparation délimitant le barreau 1. La zone de séparation définit ainsi une forme latente du spiral.

La zone de séparation exposée présente ainsi une morphologie modifiée. En effet, l'irradiation du verre de quartz entraîne une cristallisation au moins partielle du verre de quartz. L'état cristallin obtenu dépend de l'intensité du rayonnement émis par le laser femtoseconde. En tout état de cause, pour « développer » le barreau, la zone de séparation ainsi exposée peut être dissoute par attaque chimique par voie humide, typiquement par un bain à base d'acide fluohydrique ou d'hydroxyde de potassium, avec une sélectivité de 100 :1 par rapport à la matière non exposée au laser femtoseconde. La découpe du barreau 1 est ainsi réalisée avec une très grande précision.

On pourra prévoir que le barreau 1 reste attaché au wafer après découpage, en ménageant des portions d'attache. La manipulation du spiral est ainsi facilitée et un travail en batch est réalisable.

On obtient ainsi un barreau 1 en forme de spiral, réalisé en verre de quartz.

Comme illustré sur la figure 2b, un tel barreau 1 peut être utilisé, sans autre traitement, avec un balancier présentant un coefficient d'expansion thermique positif, relativement élevé, de l'ordre de +15 ppm/°K. C'est le cas de balanciers par exemple réalisés en laiton. Les propriétés physiques du verre de quartz, constituant le ressort spiral 2, permettent ainsi de compenser au moins en partie la dérive thermique de la fréquence de résonance de l'ensemble ressort spiral 2 - balancier 3 due à l'expansion du balancier.

Le barreau 1 issu du découpage du substrat peut aussi recevoir différents traitements visant à moduler son coefficient thermique de rigidité (TCE) et à compenser la dérive thermique de son module d'Young.

La figure 3 illustre un exemple de réalisation d'une compensation thermomécanique du barreau 1 de la figure 1. Le barreau 1 définit une âme 4 recouverte au moins localement d'au moins une couche externe 5 de structure ou de morphologie différente. La couche externe 5 enveloppe avantageusement l'intégralité de l'âme 4.

La couche externe 5 est par exemple réalisée à base du matériau constitutif de l'âme 4, c'est-à-dire de verre de quartz, dont la morphologie a été modifiée sur une épaisseur donnée, par une exposition à un rayonnement issu d'un laser femtoseconde. La couche externe 5 est donc constituée d'une épaisseur de morphologie modifiée 5a. On notera que, en modifiant l'énergie des pulses du rayonnement laser femtoseconde, on peut moduler la modification de la morphologie du matériau exposé. Par conséquent, on peut faire varier la valeur du coefficient thermique de rigidité du verre de quartz irradié, qui peut ainsi être réduite substantiellement et même devenir négative avec une très forte irradiation. Le comportement élastique du verre de quartz irradié est également modifié et participe à la compensation.

La figure 4 illustre une variante de réalisation d'une compensation thermomécanique du barreau 1 de la figure 1. Dans cette variante de réalisation, la couche externe 5 est réalisée avec un dépôt 5b d'un matériau présentant un coefficient thermique de rigidité de signe opposé à celui de l'âme 4. Le dépôt est effectué sur l'âme 4 en verre de quartz non modifié. La couche externe 5 est par exemple un dépôt 5b de polysilicium ou de silicium amorphe. Un tel dépôt 5b est typiquement effectué par LPCVD (Low Pressure Chemical Vapour Deposition).

La figure 5 illustre une autre variante de réalisation d'une compensation thermomécanique du barreau 1 de la figure 1, combinant les deux variantes précédentes. Ainsi, la couche externe 5 comprend une sous-couche interne correspondant à une épaisseur de morphologie modifiée 5a de l'âme 4, obtenue grâce à l'irradiation du laser femtoseconde. La couche externe 5 comprend également le dépôt 5b d'un matériau présentant un coefficient thermique de rigidité de signe opposé à celui de l'âme 4. Avantageusement, le dépôt 5b est effectué sur la sous-couche interne 5a.

Selon un autre exemple de réalisation du ressort spiral 2 conforme à l'invention, le barreau 1 présente une morphologie modifiée dans sa masse par une irradiation d'un laser femtoseconde à point focal variable. Dans ce cas, on peut avantageusement travailler au niveau wafer, sans « développer » le spiral. On se contente de former une forme latente du spiral, comme mentionné ci-dessus, en formant une zone de séparation par exposition à un laser femtoseconde. Puis, grâce au fait que le point focal du laser femtoseconde peut être focalisé en tout point du barreau, y compris de manière discrète, le barreau est irradié dans sa masse, mais en conservant au moins localement une zone périphérique d'épaisseur déterminée et non exposée au laser femtoseconde, afin de permettre un « développement » sélectif du spiral et une dissolution sélective de la zone de séparation. Le coefficient thermique de rigidité de cette zone périphérique demeure donc inchangé contrairement à la partie interne du barreau 1. On pourrait également envisager d'exposer la partie interne du barreau au laser femtoseconde, après « développement » du spiral, c'est-à-dire à partir d'un spiral découpé.

L'invention propose donc plusieurs possibilités d'un spiral à base de verre de quartz comprenant des zones de compensation thermique. Ces zones peuvent être des zones externes ou internes. Elles peuvent consister en des zones obtenues par exposition du verre de quartz à un laser femtoseconde ou, éventuellement pour une zone externe, en un dépôt d'un matériau différent.

La présente invention concerne également un procédé de fabrication du ressort spiral 2.

Selon une première variante, un tel procédé consiste, comme mentionné ci-dessus, à utiliser un laser femtoseconde pour balayer son point focal variable sur le substrat de verre de quartz et pour exposer le substrat au rayonnement dudit laser, au moins le long d'une zone de séparation délimitant le barreau 1. La zone de séparation définit ainsi une forme latente du barreau 1. La zone de séparation ainsi exposée peut être dissoute dans un bain chimique, décrit précédemment. Le spiral est au moins partiellement découpé, des portions d'attache au substrat pouvant subsister.

On applique ensuite un traitement de compensation thermique sur le spiral au moins partiellement découpé, en ménageant au moins une couche externe 5 de structure différente sur le barreau 1. La couche externe 5 peut envelopper partiellement ou totalement le barreau 1.

Le traitement de compensation peut consister à modifier la morphologie du barreau 1, sur une épaisseur donnée, par une exposition à un rayonnement issu d'un laser femtoseconde.

Le traitement de compensation peut également consister à déposer une couche d'un matériau présentant un coefficient thermique de rigidité, de signe opposé à celui du matériau constitutif du barreau 1. Un tel dépôt peut être effectué en polysilicium ou en silicium amorphe, présentant un TCE négatif. Le dépôt peut être typiquement effectué par LPCVD (Low Pressure Chemical Vapour Deposition). Un tel dépôt peut être effectué directement sur le barreau 1. On peut également effectuer un tel dépôt sur une couche externe de morphologie modifiée par exposition à un laser femtoseconde.

Les sous-couches permettent ainsi de modifier le coefficient thermique de rigidité de l'ensemble. Si l'exposition au laser femtoseconde a été trop importante et que, en conséquence, la compensation est excessive, on pourra enlever une partie de la couche exposée pour diminuer la compensation, typiquement par action chimique.

Selon une deuxième variante, le procédé consiste à délimiter avec la zone de séparation une forme latente du barreau 1 en spirale et à exposer au laser femtoseconde, au préalable de la dissolution de ladite zone de séparation, l'âme 4 de la forme latente tout en conservant une enveloppe 6 non exposée de ladite âme 4. Le procédé consiste ensuite à libérer la forme latente par l'intermédiaire de la dissolution de la zone de séparation dans un bain chimique. Un exemple du barreau 1 obtenu ainsi est illustré en section à la figure 6. L'âme 4 présente ainsi l'enveloppe 6 non modifiée dans sa morphologie.

Ainsi, l'invention offre la possibilité de préformer un grand nombre de ressorts spiraux dans une plaque ou dans un substrat de verre de quartz et d'effectuer de manière localisée un traitement au laser femtoseconde induisant une compensation mécano-thermique. Il est possible de travailler par batch, au niveau wafer, en ne désolidarisant pas les ressorts spiraux de la plaque. La manipulation et le positionnement d'une telle plaque à des fins de traitement ou de découpe sont bien plus aisés qu'une manipulation et un positionnement individuels de chaque ressort spiral.

Selon l'application visée, l'homme du métier pourra déterminer le coefficient thermique d'élasticité qu'il souhaite obtenir, soit pour produire un spiral ayant une dérive thermique aussi faible que possible, soit pour produire un spiral ayant une dérive thermique compensant celle du balancier auquel il est associé. L'homme du métier pourra déterminer, par calcul et modélisation, les localisations et les épaisseurs des zones de compensation thermique. Les possibilités de compensation mécano-thermiques sont alors extrêmement diverses et nombreuses dans le cadre de la présente invention.

Un autre avantage de l'invention réside dans le fait qu'elle permet d'obtenir un ensemble ressort spiral-balancier compensé thermiquement, en utilisant un spiral uniquement réalisé en verre de quartz non irradié par le laser femtoseconde.

De plus, on relèvera que le ressort spiral obtenu selon l'invention, est transparent. Il participe ainsi à l'esthétique du mouvement dans lequel il prend place.

Il est évident que la présente description ne se limite pas aux exemples explicitement décrits, mais comprend également d'autres modes de réalisation et/ou de mise en oeuvre. Ainsi, une caractéristique technique décrite ou une étape de mise en oeuvre décrite peut être remplacée respectivement par une caractéristique technique équivalente ou une étape équivalente, sans sortir du cadre de la présente invention.

**Revendications**

1. Ressort spiral (2) destiné à équiper un balancier (3) d'une pièce d'horlogerie mécanique, formé d'un barreau (1) en spirale, **caractérisé en ce que** le barreau (1) est formé d'une âme (4) en verre de quartz recouverte au moins localement d'au moins une couche externe (5) de structure différente pour modifier le coefficient thermique de rigidité.

2. Ressort spiral (2) selon la revendication 1, **caractérisé en ce que** la couche externe (5) est réalisée avec un dépôt d'un matériau présentant un coefficient thermique de rigidité, de signe opposé à celui de l'âme.

3. Ressort spiral (2) selon la revendication 1, **caractérisé en ce que** la couche externe (5) est réalisée avec le verre de quartz de l'âme (4), dont la morphologie a été modifiée par une exposition à un laser femtoseconde.

4. Ressort spiral (2) selon la revendication 1, **caractérisé en ce que** la couche externe (5) comprend une sous-couche externe réalisée avec un dépôt (5b) d'un matériau présentant un coefficient thermique de rigidité de signe opposé à celui de l'âme (4) et une sous-couche interne réalisée avec le verre de quartz de l'âme (4), dont la morphologie a été modifiée par une exposition à un laser femtoseconde.

5. Ressort spiral (2) selon l'une des revendications 3 ou 4, **caractérisé en ce que** le verre de quartz dont la morphologie a été modifiée, présente une structure au moins partiellement cristallisée.

6. Ensemble ressort spiral (2)-balancier (3), ledit balancier (3) présentant un coefficient thermique d'expansion positif, ledit ensemble présentant une compensation de dérive thermique de la fréquence de résonnance, **caractérisé en ce que** le matériau constitutif du ressort spiral (2) est du verre de quartz dont le coefficient thermique de rigidité est positif, agencé de manière à compenser la dérive thermique de la fréquence de résonnance due à l'expansion du balancier.

7. Procédé de fabrication d'un ressort spiral (2), consistant à découper un barreau (1) en spirale dans un substrat de verre de quartz, **caractérisé en ce qu'**il consiste à :

    - utiliser un laser femtoseconde pour balayer son point focal variable sur le substrat et pour exposer audit laser le substrat au moins le long d'une zone de séparation délimitant ainsi le barreau (1) en spirale, la zone de séparation exposée présentant ainsi une morphologie modifiée,
    - et dissoudre au moins une partie de ladite zone de séparation dans un bain chimique sélectif.

8. Procédé selon la revendication 7, **caractérisé en ce qu'**il consiste à appliquer un traitement de compensation thermique sur ledit barreau (1) au moins partiellement découpé, en recouvrant le barreau (1) d'au moins une couche externe (5) de structure différente.

9. Procédé selon la revendication 8, **caractérisé en ce que** le traitement de compensation thermique consiste à modifier la morphologie du barreau 1, sur une épaisseur donnée, par une exposition à un rayonnement issu d'un laser femtoseconde.

10. Procédé selon la revendication 8, **caractérisé en ce que** le traitement de compensation thermique consiste à déposer une couche d'un matériau présentant un coefficient thermique de rigidité, de signe opposé à celui du matériau constitutif du barreau (1).

11. Procédé selon la revendication 7, **caractérisé en ce qu'**il consiste à :

    - délimiter avec la zone de séparation une forme latente du barreau (1) en spirale,
    - exposer, au préalable de la dissolution de la zone de séparation, une âme (4) de la forme latente au laser femtoseconde en conservant une enveloppe (6) non exposée de ladite âme (4),
    - et libérer la forme latente par l'intermédiaire de la dissolution de la zone de séparation.

1

Fig. 1

5    5a

4    Fig. 3

5    5b

4

Fig. 4

5    5b    5a

4

Fig. 5

1

4    6

Fig. 6

Fig. 2a

Fig. 2b

Europäisches
Patentamt

European
Patent Office

Office européen
des brevets

**RAPPORT DE RECHERCHE EUROPEENNE**

Numéro de la demande

EP 11 19 0694

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 2 337 221 A1 (SWATCH GROUP RES & DEV LTD [CH]) 22 juin 2011 (2011-06-22) * alinéas [0006], [0007], [0010] - [0012], [0023]; figures 1-3 * | 1,2,4 | INV. G04B17/06 G04B17/22 F16F1/10 H03H9/02 B23K26/06 |
| X | EP 1 791 039 A1 (SWATCH GROUP RES & DEV LTD [CH]) 30 mai 2007 (2007-05-30) * alinéas [0020] - [0024]; figures 2-6 * | 1,3,5 | |
| X | CH 700 260 A2 (CARTIER CREATION STUDIO SA [CH]) 30 juillet 2010 (2010-07-30) * alinéas [0021], [0022], [0026], [0032]; figures 1-3 * | 6 | |
| A | WO 2011/095780 A1 (LEVINGSTON GIDEON RORY [FR]) 11 août 2011 (2011-08-11) * pages 7,9 * | 1-5 | |
| X | DE 10 2008 061182 A1 (DAMASKO KONRAD [DE]) 10 juin 2010 (2010-06-10) * alinéa [0012] - alinéa [0018]; figures 1,3,4 * | 7 | DOMAINES TECHNIQUES RECHERCHES (IPC) |
| A | FR 2 871 080 A1 (SEMON GUY [FR]) 9 décembre 2005 (2005-12-09) * page 7 - page 9 * | 7-11 | G04B G04D F16F H03H B41C B23K |
| A | DE 101 27 733 A1 (SILICIUM ENERGIESYSTEME E K DR [DE]) 6 février 2003 (2003-02-06) * le document en entier * | 7-11 | |

Le présent rapport a été établi pour toutes les revendications

| Lieu de la recherche | Date d'achèvement de la recherche | Examinateur |
|---|---|---|
| La Haye | 13 novembre 2012 | Mérimèche, Habib |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

& : membre de la même famille, document correspondant

EPO FORM 1503 03.82 (P04C02)

Europäisches
Patentamt
European
Patent Office
Office européen
des brevets

## REVENDICATIONS DONNANT LIEU AU PAIEMENT DE TAXES

La présente demande de brevet européen comportait lors de son dépôt les revendications dont le paiement était dû.

☐ Une partie seulement des taxes de revendication ayant été acquittée dans les délais prescrits, le présent rapport de recherche européenne a été établi pour les revendications pour lesquelles aucun paiement n'était dû ainsi que pour celles dont les taxes de revendication ont été acquittées, à savoir les revendication(s):

☐ Aucune taxe de revendication n'ayant été acquittée dans les délais prescrits, le présent rapport de recherche européenne a été établi pour les revendications pour lesquelles aucun paiement n'était dû.

## ABSENCE D'UNITE D'INVENTION

La division de la recherche estime que la présente demande de brevet européen ne satisfait pas à l'exigence relative à l'unité d'invention et concerne plusieurs inventions ou pluralités d'inventions, à savoir:

```
voir feuille supplémentaire B
```

☒ Toutes les nouvelles taxes de recherche ayant été acquittées dans les délais impartis, le présent rapport de recherche européenne a été établi pour toutes les revendications.

☐ Comme toutes les recherches portant sur les revendications qui s'y prêtaient ont pu être effectuées sans effort particulier justifiant une taxe additionnelle, la division de la recherche n'a sollicité le paiement d'aucune taxe de cette nature.

☐ Une partie seulement des nouvelles taxes de recherche ayant été acquittée dans les délais impartis, le présent rapport de recherche européenne a été établi pour les parties qui se rapportent aux inventions pour lesquelles les taxes de recherche ont été acquittées, à savoir les revendications:

☐ Aucune nouvelle taxe de recherche n'ayant été acquittée dans les délais impartis, le présent rapport de recherche européenne a été établi pour les parties de la demande de brevet européen qui se rapportent à l'invention mentionnée en premier lieu dans les revendications, à savoir les revendications:

☐ Le present rapport supplémentaire de recherche européenne a été établi pour les parties de la demande de brevet européen qui se rapportent a l'invention mentionée en premier lieu dans le revendications (Règle 164 (1) CBE)

9

Europäisches
Patentamt

European
Patent Office

Office européen
des brevets

**ABSENCE D'UNITÉ D'INVENTION
FEUILLE SUPPLÉMENTAIRE B**

Numéro de la demande

EP 11 19 0694

La division de la recherche estime que la présente demande de brevet européen ne satisfait pas à l'exigence relative à l'unité d'invention et concerne plusieurs inventions ou pluralités d'inventions, à savoir :

```
    1. revendications: 1-5

          Invention 1

    1.1. revendication: 6

          Invention 2
                            ---

    2. revendications: 7-11

          Invention 3
                            ---
```

Prière de noter que toutes les inventions mentionnées sous point 1, qui ne sont pas nécessairement liées par un concept inventif commun, ont pu être recherchées sans effort particulier justifiant une taxe additionnelle.

EPO FORM P0402

**ANNEXE AU RAPPORT DE RECHERCHE EUROPEENNE
RELATIF A LA DEMANDE DE BREVET EUROPEEN NO.**

EP 11 19 0694

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-11-2012

| Document brevet cité au rapport de recherche | Date de publication | Membre(s) de la famille de brevet(s) | Date de publication |
|---|---|---|---|
| EP 2337221 A1 | 22-06-2011 | CN 102687394 A | 19-09-2012 |
| | | EP 2337221 A1 | 22-06-2011 |
| | | EP 2514094 A1 | 24-10-2012 |
| | | TW 201136154 A | 16-10-2011 |
| | | US 2012230159 A1 | 13-09-2012 |
| | | WO 2011072960 A1 | 23-06-2011 |
| EP 1791039 A1 | 30-05-2007 | CN 101361027 A | 04-02-2009 |
| | | EP 1791039 A1 | 30-05-2007 |
| | | EP 1958031 A2 | 20-08-2008 |
| | | JP 2009517637 A | 30-04-2009 |
| | | KR 20080072002 A | 05-08-2008 |
| | | US 2009016173 A1 | 15-01-2009 |
| | | WO 2007059876 A2 | 31-05-2007 |
| CH 700260 A2 | 30-07-2010 | AUCUN | |
| WO 2011095780 A1 | 11-08-2011 | EP 2531743 A1 | 12-12-2012 |
| | | WO 2011095780 A1 | 11-08-2011 |
| DE 102008061182 A1 | 10-06-2010 | AUCUN | |
| FR 2871080 A1 | 09-12-2005 | CN 101048256 A | 03-10-2007 |
| | | FR 2871080 A1 | 09-12-2005 |
| | | RU 2371290 C2 | 27-10-2009 |
| DE 10127733 A1 | 06-02-2003 | AUCUN | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- CH 307683
- EP 1791039 A